Europäisches Patentamt

European Patent Office

Office européen des brevets

(19)

(11) Publication number : **0 515 037 A1**

## (12) EUROPEAN PATENT APPLICATION

(21) Application number : **92303591.9**

(22) Date of filing : **22.04.92**

(51) Int. Cl.$^5$ : **H01H 85/10, H01H 85/08**

(30) Priority : **22.04.91 GB 9108567**

(43) Date of publication of application :
**25.11.92 Bulletin 92/48**

(84) Designated Contracting States :
**AT DE GB**

(71) Applicant : **AB Electronic Components Limited
Abercynon
Mountain Ash Mid-Glamorgan CF45 4SF
Wales (GB)**

(72) Inventor : **Auerswald, Gerd
Haunsbergstrasse 5
W-8228 Freilassing (DE)**

(74) Representative : **Luckhurst, Anthony Henry
William et al
MARKS & CLERK 57-60 Lincoln's Inn Fields
London WC2A 3LS (GB)**

(54) **Fuse.**

(57)   A fuse 14 for a thin-film or thick-film circuit is
formed by depositing an electrically conducting
track 15 on a substrate. The fuse 14 is preferably
formed on a thermally insulating support layer
16 and may be provided as a discrete compo-
nent for surface mounting in a hybrid circuit. A
glass layer 21 overlays the track 15 and melts
into the gap formed in the track 15 as the fuse
14 blows.

FIG.3

Jouve, 18, rue Saint-Denis, 75001 PARIS

The present invention relates to a fuse, and in particular to a fuse for thick-film and thin-film circuits.

Fuses as discrete components are well known. Typically a wire is positioned centrally in a glass tube, a circuit current passing through the wire. When the current exceeds a predetermined level for a period of time the wire will melt, thus breaking the circuit. The amount of current and the time span before the fuse wire melts are inter-related and determined by the design parameters of the fuse. These fuses cannot or cannot easily be incorporated in thick-film and thin-film hybrid circuits, that is circuits which utilise components and tracks formed by deposition on a substrate together with discrete components mounted on a substrate.

For such hybrid circuits, it is known to use a fuse bow. A conductor is pre-stressed mechanically and its ends are then soldered to conducting tracks on the substrate. When the current/time limits are exceeded, the solder at one end will melt and so release the conductor end which springs away from the track to break the circuit. Fuse bows are expensive to incorporate in such circuits.

A first aspect of the invention provides a fuse comprising an electrically conducting track portion deposited on a substrate by thin-film or thick-film techniques, the geometry and material of the track portion being chosen so that the track will melt when a predetermined current passes through the track.

A second aspect of the present invention provides a fuse comprising an electrically conducting track portion on a substrate, the track portion incorporating a constriction of reduced cross-sectional area along its length, whereby the track portion will melt at or near the constriction when the current passing through the track portion exceeds a predetermined amount for a predetermined period of time.

The fuse may be formed by thick-film or thin-film techniques. The track portion may be deposited directly on the substrate as part of a circuit. However, it is preferred that the track portion be supported on a thermally insulating substrate. This might be deposited on the circuit substrate or the fuse may be provide as a discrete component, comprising the thermally insulating substrate and the track portion, for mounting on the main circuit substrate, as with other discrete components in a hybrid circuit.

Surface tension effects will normally be sufficient to cause a gap to form in the track portion when it melts. When the current/time limits are exceeded, the melting of the track portion can be quite violent and sputtered parts of the track portion may reform to complete the circuit. Very preferably the track portion is coated with layer of material which will melt as the track portion heats up to its melting point, and flow into and around the gap formed in the track portion as it melts, thus preventing the conducting track portion from re-forming. Preferably the coating material is of a type which will wet the substrate. The coating material preferably contains a flux or other composition which will improve the wetting of the substrate.

A third aspect of the invention provides a method of forming a fuse in a thin-film or thick-film circuit device, the method comprising depositing an electrically conducting track portion which is arranged to melt when a predetermined current passes through the track portion for a predetermined length of time.

Other preferred features and advantages of the invention will be apparent from the following description and the accompanying claims.

The invention will be further described by way of example with reference to the accompanying drawings, in which:

Figure 1 illustrates a fuse forming an embodiment of the invention;

Figure 2 shows a fuse of the invention in a hybrid circuit;

Figure 3 shows a fuse of the invention as a surface mounted device; and

Figure 4 illustrate the variation of current intensity and release time for a fuse relative to the geometry of the track portion.

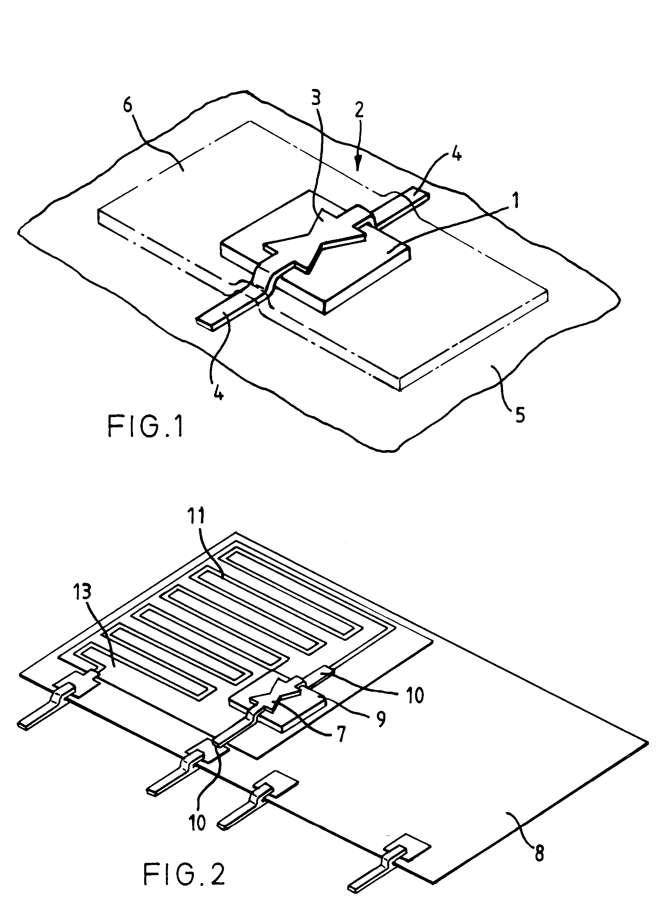

In figure 1, a fuse forming a first embodiment of the invention comprises a thermally insulating support layer 1 on which is deposited an electrically conducting track 2. The track 2 comprises a shaped track portion 3 connected at each end to electrodes 4 which connect with the circuit (not shown) to be protected. The support layer 1 and electrodes 4 are deposited or otherwise attached onto a ceramic substrate 5 (which, for example, carries a thin-film or thick-film circuit), and a glass passivation layer 6 is deposited over the shaped region 3 and support layer 1.

The region 3 is designed according to the maximum current which must be carried by the fuse and the speed at which it must melt, i.e., blow. These parameters may be determined by the material of the region 3, the shape (in plan view) of the region, and the thickness.

The required shape and thickness can be achieved by thin-film or thick-film deposition techniques such as sputtering, vacuum deposition, laser trimming, printing, etching, etc.

In the embodiment of Figure 2, a fuse is incorporated in a hybrid circuit on a ceramic substrate 8. A thermally insulating film 9 is deposited on the substrate and then overlayed with an electrically conducting track portion 7 and electrodes 10 which are connected to the thin-film or thick-film circuit 11 on the substrate 8. A glass passivation layer 13 overlays the track 7, circuit 11, electrodes 10 and substrate 9.

The ceramic substrate 8 is thermally conducting so that the circuit 11 can carry a high current density. In accordance with the invention, the fuse 7 could be formed by means of a constriction in an eletrically conducting track 13 deposited directly on the substrate 8.

However, as shown in the embodiment, it is preferred to form the fuse by deposition of a track portion on a thermally insulating support to facilitate control over the operating parameters of the fuse.

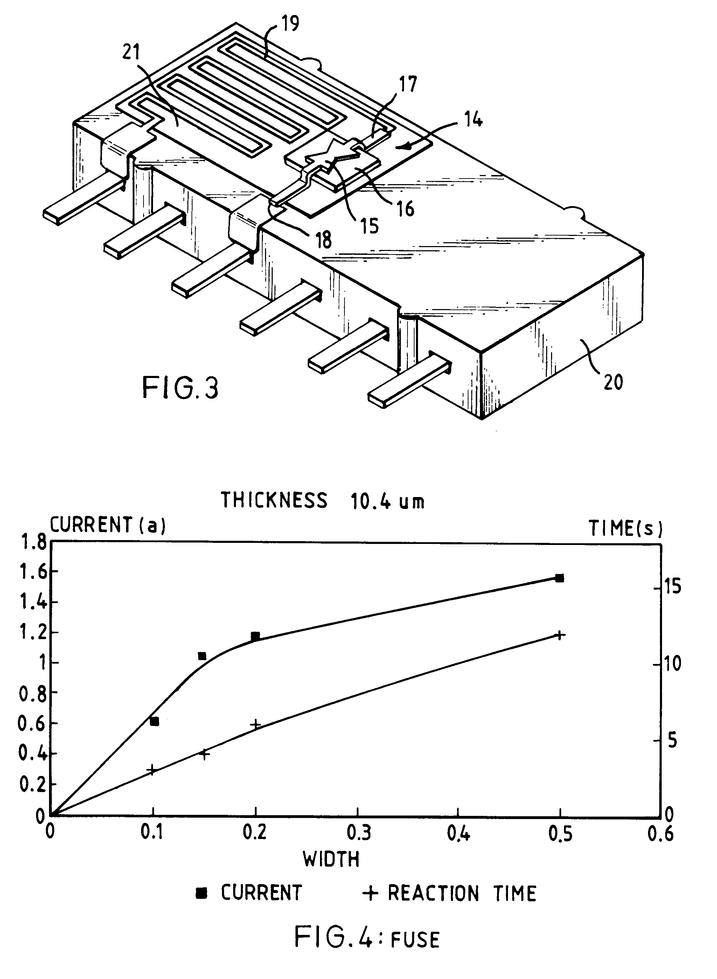

In the embodiment of Figure 3, a fuse 14 in accordance with the invention is provided as a surface mounted device and is shown as a conducting track portion 15 on an insulating support 16. Electrodes 17 are soldered or adhered to conducting tracks 18, 19 on a ceramic substrate 20. A glass passivation layer 21 overlays the fuse 14 and the adjacent circuit.

Figure 4 illustrates the variation of fuse breakdown time (reaction time) and breakdown current for a fuse track portion of constant thickness and different widths. It will be appreciated that the operating parameters of the fuse (ie breakdown current and reaction time) can be adjusted by varying the material of the conducting track portion, the geometry of the track (length, width, thickness), and also the degree of thermal insulation about the track.

The fuse of the invention may comprise a plurality of track portions which can be cut or otherwise disconnected from the circuit to achieve the desired fuse rating.

The material of the track portion may include a wetting agent or other substances to aid the flow of the material as it melts.

The track portion and/or the electrodes joining the track portion to the adjacent circuitry are preferably formed by thin-film or thick-film techniques.

The track portion itself may be formed, or adjusted after initial deposition, by a variety of techniques such as evaporation, lasing, sputtering, induced crystal growth.

The material of the track portion may be an alloy or otherwise selected to provide the desired fuse rating.

The ceramic substrate is preferably of 96% alumina.

It will be appreciated that the fuse may be formed as a discrete component for use in electrical circuits. Preferably the component is a surface mounted device.

## Claims

1. A fuse comprising an electrically conducting track portion deposited on a substrate by thin-film or thick-film techniques, the geometry and material of the track portion being chosen so that the track portion will melt when a predetermined current passes through the track portion.

2. A fuse as claimed in claim 1, including an electrode for electrically connecting the track portion to a circuit.

3. A fuse comprising an electrically conducting track portion on a substrate, the track portion incorporating a constriction of reduced cross-sectional area along its length, whereby the track portion will melt at or near the constriction when the current passing through the track portion exceeds a predetermined amount for a predetermined period of time.

4. A fuse as claimed in Claim 3, wherein the track is deposited on a ceramic substrate as part of an electrical circuit.

5. A fuse as claimed in Claim 3 or 4, wherein the track portion is deposited on a thermally insulating support.

6. A fuse as claimed in any one of Claims 1 to 5, wherein the track portion is formed between electrically conducting track portions by a technique such as evaporation, laser trimming, sputtering, and/or induced crystal growth.

7. A fuse as claimed in any one of Claims 1 to 6, wherein the track portion is formed from a combination of substances.

8. A fuse as claimed in any one of Claims 1 to 7, wherein the track portion is mounted separately on the substrate relative to associated circuitry.

9. A fuse as claimed in any one of Claims 1 to 8, wherein the track portion is coated by a film which will melt as the fuse blows, to coat the substrate in the region of the interrupted track portion.

10. A fuse as claimed in Claim 9, wherein the material of the coating incorporates a substance to facilitate wetting of the substrate.

11. A method of forming a fuse in a thin-film or thick-film circuit device, the method comprising depositing an electrically conducting track portion which is arranged to melt when a predetermined current passes through the track portion for a predetermined length of time.

12. A method as claimed in Claim 11, wherein the track portion is deposited on a thermally insulating support.

13. A method as claimed in Claim 11 or 12, wherein the track portion is formed on a support as a discrete component which is then incorporated in the device.

FIG.1

FIG.2

FIG.3

THICKNESS 10.4 um

CURRENT (a)                                                    TIME(s)

WIDTH

■ CURRENT        + REACTION TIME

FIG.4: FUSE

European Patent

Office

# EUROPEAN SEARCH REPORT

Application Number

| | DOCUMENTS CONSIDERED TO BE RELEVANT | | EP 92303591.9 |
|---|---|---|---|

| Category | Citation of document with indication, where appropriate, of relevant passages | Relevant to claim | CLASSIFICATION OF THE APPLICATION (Int. Cl.5) |
|---|---|---|---|
| A | <u>DE - A - 3 728 489</u><br>(SIEMENS AG)<br>* Totality *<br>-- | 1,3,4,<br>6,13 | H 01 H 85/10<br>H 01 H 85/08 |
| A | <u>GB - A - 2 195 064</u><br>(SALPLEX LIMITED)<br>* Totality *<br>-- | 1,2,3,<br>5,12,<br>13 | |
| A | <u>FR - A - 2 661 777</u><br>(BATELLE MEMORIAL INSTITUTE)<br>* Abstract; claims;<br>fig. 4 *<br>-- | 1,2,3 | |
| A | <u>GB - A - 2 089 148</u><br>(WICKMANN-WERKE)<br>* Totality *<br>-- | 1,3,9,<br>13 | |
| A | <u>US - A - 3 500 276</u><br>(A.R. HINGORNAY)<br>* Totality *<br>---- | 1,2,3 | TECHNICAL FIELDS SEARCHED (Int. Cl.5)<br><br>H 01 H 85/00 |

The present search report has been drawn up for all claims

| Place of search | Date of completion of the search | Examiner |
|---|---|---|
| VIENNA | 04-09-1992 | ERBER |